# FASCICULE DE BREVET EUROPEEN

(11) **EP 1 426 328 B1**
(45) Date de publication et mention de la délivrance du brevet: **23.05.2018**
(21) Numéro de dépôt: 03104318.5
(22) Date de dépôt: 21.11.2003
(51) Int. Cl.: C23C 16/02, C23C 16/24, C23C 16/28, C30B 29/06, C30B 29/08, C30B 29/60, H01L 29/788, H01L 29/06

(54) **Procédé de réalisation par CVD de nano-structures de matériau semi-conducteur sur diélectrique, de tailles homogènes et contrôlées**
Verfahren zur Herstellung von Halbleiter-Nanostrukturen mit gelenkten homogenen Grössen durch CVD-Verfahren über Dielektrikum
Method for manufacturing of uniformly sized and controlled semi-conductor nano structures by CVD process on dieletric

(30) Priorité: 22.11.2002 FR 0214658
(43) Date de publication de la demande: 09.06.2004
(73) Titulaire: Commissariat à l'Énergie Atomique et aux Énergies Alternatives, 75015 Paris (FR)
(72) Inventeur: Mazen, Frédéric, 38000 Grenoble (FR); Baron, Thierry, 38600 Fontaine (FR); Hartmann, Jean-Michel, 38240 Meylan (FR); Semeria, Marie-Noëlle, 38250 Saint-Nizier-du-Moucherotte (FR)
(74) Mandataire: Ahner, Philippe

(56) Documents cités:
- WO-A-2004/021423
- MADHUKAR S ET AL: "CVD growth of Si nanocrystals on dielectric surfaces for nanocrystal floating gate memory application" MICROCRYSTALLINE AND NANOCRYSTALLINE SEMICONDUCTORS - 2000. SYMPOSIUM (MATERIALS RESEARCH SOCIETY SYMPOSIUM PROCEEDINGS VOL.638), MICROCRYSTALLINE AND NANOCRYSTALLINE SEMICONDUCTORS - 2000. SYMPOSIUM, BOSTON, MA, USA, 27-30 NOV. 2000, pages F5.2.1-6, XP008019824 2001, Warrendale, PA, USA, Mater. Res. Soc, USA
- FERNANDES A ET AL: "Memory characteristics of Si quantum dot devices with SiO/sub 2//ALD Al/sub 2/O/sub 3/ tunneling dielectrics" INTERNATIONAL ELECTRON DEVICES MEETING. TECHNICAL DIGEST (CAT. NO.01CH37224), INTERNATIONAL ELECTRON DEVICES MEETING. TECHNICAL DIGEST, WASHINGTON, DC, USA, 2-5 DEC. 2001, pages 7.4.1-4, XP010575097 2001, Piscataway, NJ, USA, IEEE, USA ISBN: 0-7803-7050-3
- MAZEN F ET AL: "A two steps CVD process for the growth of silicon nano-crystals" APPL SURF SCI;APPLIED SURFACE SCIENCE JUL 6 2003, vol. 214, no. 1-4, 6 juillet 2003 (2003-07-06), pages 359-363, XP002248266
- SCHMIDT O G ET AL: "SELF-ASSEMBLED GE/SI DOTS FOR FASTER FIELD-EFFECT TRANSISTORS" IEEE TRANSACTIONS ON ELECTRON DEVICES, IEEE INC. NEW YORK, US, vol. 48, no. 6, juin 2001 (2001-06), pages 1175-1179, XP001082399 ISSN: 0018-9383
- KAMINS T I ET AL: "LITHOGRAPHIC POSITIONING OF SELF-ASSEMBLED GE ISLANDS ON SI(001)" APPLIED PHYSICS LETTERS, AMERICAN INSTITUTE OF PHYSICS. NEW YORK, US, vol. 71, no. 9, 1 septembre 1997 (1997-09-01), pages 1201-1203, XP000720233 ISSN: 0003-6951

## Description

### DOMAINE TECHNIQUE

L'invention concerne un procédé de réalisation de nano-structures de matériau semi-conducteur sur un diélectrique par dépôt chimique en phase vapeur (CVD), lesdites nano-structures étant de tailles homogènes et contrôlées. Le matériau semi-conducteur est en particulier du silicium ou du germanium.

Ces nano-structures ainsi réalisées sont destinées à la réalisation de dispositifs électroniques, optiques ou optoélectroniques, et en particulier, à la réalisation de dispositifs à blocage de Coulomb mettant en oeuvre des boîtes quantiques.

Les applications visées plus particulièrement dans la présente invention sont les cellules mémoires à grille granulaires et les DOTFET, qui sont des transistors à effet de champ qui mettent en jeu des nano-structures.

L'amélioration constante des performances des circuits micro-électroniques requiert un taux d'intégration toujours plus important de leur composant élémentaire, le MOSFET. Jusqu'à présent, l'industrie micro-électronique a toujours pu diminuer les dimensions du MOSFET en optimisant les procédés technologiques et ceci, sans rencontrer de limitations physiques majeures à son fonctionnement. Cependant, à court ou moyen terme, la SIA Roadmap prévoit une longueur de grille de l'ordre de 35 nm en deçà de laquelle des effets quantiques perturberont son bon fonctionnement. Il faut donc développer des solutions de remplacement à la technologie CMOS.

Une des voies les plus prometteuses est l'utilisation des propriétés de rétention de charge/blocage de coulomb de nano-structures semi-conductrices. Une forte recherché est donc menée actuellement pour intégrer ces nano-structures, principalement réalisées en silicium, dans des dispositifs.

Pour ces applications particulières, les nano-structures doivent être isolées électriquement du substrat par une couche de diélectrique. Elles doivent également être isolées spatialement, c'est-à-dire qu'elles ne doivent pas être en contact les unes avec les autres. De plus, la taille et la densité des nano-structures doivent être maîtrisées avec précision : leur dimension doit être inférieure à 10 nm et leur densité spatiale sur le substrat doit être élevée, c'est-à-dire varier entre 10⁹ et quelques 10¹² nano - structures/cm².

Il existe plusieurs procédés pour réaliser ces nano-structures, comme par exemple, le dépôt chimique en phase vapeur (CVD) qui permet notamment de déposer sur des diélectriques des cristaux de silicium de dimension nanométrique (avec un diamètre inférieur à 10nm).

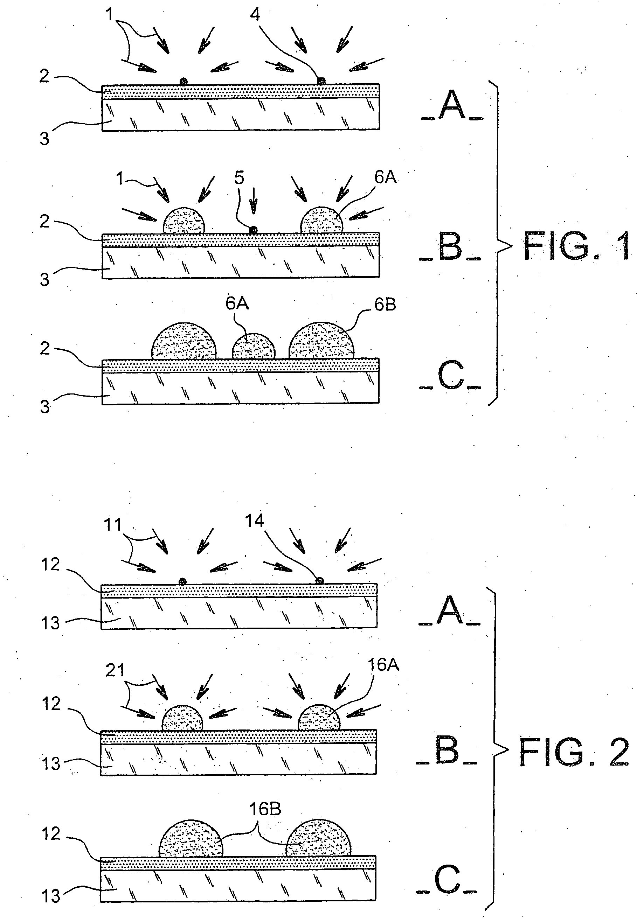

Le processus de formation d'une couche de silicium sur un diélectrique par CVD, à partir de précurseurs tels que le silane ou le disilane, est de type Volmer-Webber : il se forme d'abord des îlots ayant trois dimensions qui croissent jusqu'à la coalescence, avant de former une couche continue. En stoppant la croissance des îlots pendant les premiers stades du dépôt, on obtient des îlots cristallins de dimension nanométrique. Mais avec cette méthode, les phases de nucléation et de croissance sont simultanées. Ainsi, lorsqu'on envoie le gaz précurseur 1 sur le diélectrique 2 (figures 1A et 1B), les premiers germes stables 4 formés croissent pendant que de nouveaux germes 5 apparaissent (figure 1B). On obtient donc au final un diélectrique présentant des nano-structures de tailles variées 6A et 6B (figure 1C), la taille des nano-cristaux silicium obtenus pouvant être inférieure à 10 nm. (Notons que dans le cas représenté par les figures 1A à 1C, on a affaire à un substrat composite comprenant un substrat 3 recouvert d'une couche de matériau diélectrique 2).
Par cette méthode, les nano-cristaux silicium sont également isolés les uns des autres. De plus, selon le document **[1]** référencé à la fin de la présente description, les densités spatiales des nano-structures obtenues par CVD varient de 10⁹ à quelques 10¹²/cm² suivant les conditions de dépôt et la nature chimique du substrat. La principale limitation de cette technique est la forte dispersion .en taille, de l'ordre de 50%, des nano-cristaux silicium.

Cela a pour effet de limiter la qualité et les performances des dispositifs basés sur de telles structures.

A titre d'exemple, le document **[6]** décrit également la formation d'un dispositif mémoire à base de nano-structures de silicium sur un diélectrique. Les nano-structures de silicium sont mises à croître par LPCVD dans un four avec une pression partielle de SiH₄ variant entre 35-200 mTorr et une température comprise entre 570-620°C. On obtient ainsi des nano-structures avec deux densités différentes, 7x10¹¹/cm² et 10¹²/cm².

De même, des nano-structures de germanium peuvent aussi être intégrées dans des dispositifs. Dans certains cas, les différences de propriétés physiques entre le silicium et le germanium peuvent rendre ce dernier matériau plus intéressant pour les applications visées par l' invention. En effet, le germanium possède une bande interdite plus petite que celle du silicium, ce qui permet un meilleur confinement des charges et un chargement plus facile des nano-structures.

Or, le dépôt de nano-structures de germanium sur diélectrique par CVD n'est pas mentionné dans la littérature. En effet, le précurseur du germanium le plus couramment utilisé en CVD, le germane, n'engendre pas de dépôt sur la silice. A ce sujet, il est connu que le germanium croît sélectivement sur le silicium par rapport à de la silice par CVD à partir de germane (voir le document **[2]** référencé à la fin de la présente description).

Le dépôt de germanium par CVD sur la silice a cependant été étudié, mais dans un contexte différent de la présente invention. Selon, le document **[3]** référencé à la fin de la description, il s'agissait de remplacer le poly-silicium dans les grilles des transistors MOS par le poly-germanium. Dans ce cadre, les structures de germanium réalisées étaient des couches continues de poly-germanium de plusieurs dizaines de nanomètres d'épaisseur. Pour déposer les couches de poly-germanium sur de la silice par CVD de germane,il était proposé de déposer au préalable une couche continue de poly-silicium de quelques nanomètres d'épaisseur sur laquelle pouvait croître la couche continue de poly-germanium par CVD de germane.

WO2004/021423, qui ne fait partie de l'état de la technique opposable à la présente invention qu'au titre de l'article 54(3) CBE 1973 et que pour les seuls Etats contractants DE, FR, GB et IT, décrit un procédé de réalisation de nanocristaux sur une couche de diélectrique par dépôt chimique en phase vapeur. Ce procédé comprend une phase de nucléation, au cours de laquelle la couche de diélectrique est exposée à un premier gaz précurseur pour former des germes sur la couche diélectrique, et une phase de croissance, au cours de laquelle la couche de diélectrique est exposée à un second gaz précurseur pour faire croître des nanocristaux sur les germes.

### EXPOSÉ DE L'INVENTION

L'invention propose un procédé de réalisation de nano-structures de matériau semi-conducteur sur un substrat de matériau diélectrique par dépôt chimique en phase vapeur (CVD) ne présentant pas les problèmes de l'art antérieur.

Pour tous les Etats contractants désignés autres que DE, FR, GB et IT, le procédé selon la revendication 1 de l'invention comprend les étapes suivantes :
- une étape de formation sur le substrat de germes stables d'un premier matériau semi-conducteur sous forme d'îlots, par dépôt CVD à partir d'un précurseur du premier matériau semi-conducteur choisi pour que le matériau diélectrique accepte la formation desdits germes,
- une étape de formation de nano-structures d'un deuxième matériau semi-conducteur à partir des germes stables du premier matériau semi-conducteur, par dépôt CVD à partir d'un précurseur choisi pour engendrer un dépôt sélectif du deuxième matériau semi-conducteur uniquement sur lesdits germes.

En d'autres termes, le précurseur du deuxième matériau est choisi parmi les précurseurs qui permettent d'engendrer un dépôt sélectif sur le germe formé pendant la première étape de CVD, préférentiellement au substrat diélectrique.

Selon un premier mode de réalisation, le premier et le deuxième matériau semi-conducteur seront du silicium.

Selon un deuxième mode de réalisation, le premier matériau semi-conducteur sera du silicium et le deuxième matériau semi-conducteur sera du germanium.

En d'autres termes, le procédé selon l'invention permet, d' une part, de déposer des nano-structures de germanium isolées les unes des autres sur un matériau diélectrique par GVD ; si le substrat de matériau diélectrique est en silice et qu'on utilise le germane comme précurseur du germanium, on n'aura, grâce à ce procédé, pas besoin de déposer une couche intermédiaire continue de silicium sur le substrat de matériau diélectrique de silice. Par ce procédé, les nano-structures auront une taille homogène et contrôlée, et leur densité variera entre 10⁹ et quelques 10¹²/cm². Avantageusement, en jouant sur les paramètres de température et pression du précurseur lors du dépôt, on pourra obtenir des nano-structures soit cristallines, soit amorphes.

D' autre part, l'invention permet également de déposer, sur un matériau diélectrique, des nano-structures de silicium isolées les unes des autres par CVD avec une dispersion en taillé moindre que celle connue de l'art antérieur.

Préférentiellement, le substrat de matériau diélectrique sera choisi de manière à ce qu' il soit le plus réactif possible avec le précurseur du premier matériau semi-conducteur.

Selon un premier mode de réalisation, ledit substrat de matériau diélectrique sera choisi parmi le groupe composé de SiO₂, SiO₂ comprenant une forte densité de groupes Si-OH à sa surface, Si₃N₄, Al₂O₃ et HfO₂.

Avantageusement, l'étape de formation de germes stables d'un premier matériau semi-conducteur est réalisée pendant un temps d'exposition choisi en fonction de la densité de germes souhaitée; plus le temps d'exposition sera long, plus la densité de germes sera élevée.

L'étape de formation de nano-structures d'un deuxième matériau semi-conducteur à partir des germes stables du premier matériau semi-conducteur est quant à elle réalisée pendant un temps d'exposition choisi avantageusement en fonction de la taille des nano-structures voulue; plus le temps d'exposition sera long, plus la taille des nano-structures sera grande.

Avantageusement, les étapes de CVD sont réalisées pour une pression partielle de précurseur faible. En effet, si la pression partielle des précurseurs est faible, la vitesse de croissance des germes sera lente et on pourra ainsi plus facilement contrôler la taille des nano-structures.

Selon un cas particulier de l'invention, le précurseur du premier matériau semi-conducteur sera le silane.

Dans ce cas, la formation des germes du premier matériau semi-conducteur se fera à une température comprise entre 550°C et 700°C et pour une pression partielle du silane inférieure à environ 133 Pa (1 Torr) . L' intervalle de température de dépôt est choisi de manière à ce que la température soit suffisamment élevée pour que le précurseur puisse se dissocier et engendrer la formation d'un germe cristallin, et également la plus basse possible afin de limiter la vitesse decroissance des germes.

Dans un cas particulier dans lequel l'étape de formation de germes stables d'un premier matériau semi-conducteur se faisant à des pressions partielles inférieures à environ 1,33 Pa (10 mTorr), le temps d'exposition du substrat au précurseur du premier matériau semi-conducteur est inférieur à 15 minutes.

Dans un autre cas particulier dans lequel l'étape de formation de germes stables du premier matériau semi-conducteur se faisant à des pressions partielles inférieures à environ 133 Pa (1 Torr), le temps d'exposition du substrat au précurseur du premier matériau semi-conducteur est inférieur à 1 minute.

Avantageusement, lorsque le premier et le deuxième matériau semi-conducteur déposé sur ledit substrat, pour l'un, et sur lesdits germes, pour l'autre, sont du silicium, le précurseur du deuxième matériau semi-conducteur est le dichlorosilane.

Avantageusement, lorsque le premier matériau semi-conducteur déposé sur ledit substrat est du silicium et que le deuxième matériau semi-conducteur déposé sur lesdits germes est du germanium, le précurseur du deuxième matériau semi-conducteur est le germane.

Ainsi, lorsque le précurseur du deuxième matériau semi-conducteur est le dichlorosilane ou le germane, l'étape de formation de nano-structures est réalisée à une température comprise entre 300°C et 1000°C et pour une pression partielle du précurseur inférieure à environ 133 Pa (1 Torr).

Avantageusement, le procédé comprend en outre une étape de dopage des nano-structures par co-déposition ou par implantation avec des éléments tels que le bore, le phosphore, l'arsenic ou l'erbium.

Avantageusement, le procédé comprend en outre une étape d'encapsulation des nano-structures par dépôt d'un diélectrique.

Pour les Etats contractants désignés DE, FR, GB et IT, le procédé de réalisation de nano-structures de matériau semi-conducteur sur un substrat de matériau diélectrique par dépôt chimique en phase vapeur (CVD) selon la revendication 1 de l'invention comprend les étapes suivantes :
- une étape de formation sur le substrat de germes stables d'un premier matériau semi-conducteur sous forme d'îlots, par dépôt CVD à partir d'un précurseur du premier matériau semi-conducteur choisi pour que le matériau diélectrique accepte la formation desdits germes,
- une étape de formation de nano-structures d'un deuxième matériau semi-conducteur à partir des germes stables du premier matériau semi-conducteur, par dépôt CVD à partir d'un précurseur choisi pour engendrer un dépôt sélectif du deuxième matériau semi-conducteur uniquement sur lesdits germes,
le premier et le deuxième matériau semi-conducteur étant du silicium,
et le procédé étant caractérisé en ce que le précurseur du deuxième matériau semi-conducteur est le dichlorosilane.

Le procédé de réalisation de nano-structures de matériau semi-conducteur sur un substrat de matériau diélectrique par dépôt chimique en phase vapeur (CVD) selon la revendication 2 de l'invention peut également être caractérisé en ce qu'il comprend les étapes suivantes :
- une étape de formation sur le substrat de germes stables d'un premier matériau semi-conducteur sous forme d'îlots, par dépôt CVD à partir d'un précurseur du premier matériau semi-conducteur choisi pour que le matériau diélectrique accepte la formation desdits germes,
- une étape de formation de nano-structures d'un deuxième matériau semi-conducteur à partir des germes stables du premier matériau semi-conducteur, par dépôt CVD à partir d'un précurseur choisi pour engendrer un dépôt sélectif du deuxième matériau semi-conducteur uniquement sur lesdits germes,
le premier matériau semi-conducteur étant du silicium et le deuxième matériau semi-conducteur étant du germanium,
et le procédé étant caractérisé en ce que le précurseur du deuxième matériau semi-conducteur est le germane.

Avantageusement, l'étape de formation de nano-structures est réalisée à une température comprise entre 300°C et 1000°C et pour une pression partielle du précurseur inférieure à environ 133 Pa (1 Torr).

Avantageusement, le procédé comprend en outre une étape de dopage des nano-structures par co-déposition ou par implantation avec des éléments choisis parmi le bore, le phosphore, l'arsenic ou l'erbium.

Avantageusement, le procédé comprend en outre une étape d'encapsulation des nano-structures par dépôt d'un diélectrique.

Avantageusement, le précurseur du premier matériau semi-conducteur est le silane.

Les procédés selon l'invention permettent de réaliser des nano-structures de taille homogène et contrôlée.

Ces nano-structures peuvent être dopées par co-déposition ou par implantation avec des éléments tels que le bore, le phosphore, l'arsenic ou l'erbium.

Ces nano-structures peuvent être encapsulées par dépôt d'un diélectrique.

Des dispositifs présentant des nano-structures obtenues par le biais d'un des procédés selon l'invention peuvent être réalisés.

Un tel dispositif peut par exemple être une cellule mémoire possédant une grille flottante qui est composée de nano-structures réalisées par le biais d'un des procédés selon l'invention,

Cette cellule mémoire peut par exemple être un DOTFET.

L'invention présente de nombreux autres avantages.

Tout d'abord, comme la gamme de densité spatiale des nano-structures obtenue avec ce procédé est identique à celle des germes déposés dans la première étape de CVD, la taille des nano-structures obtenues au final peut être choisie dans un grand éventail de valeurs où la taille minimale dés nano-structures est de l'ordre d'un nanomètre et la taille maximale est celle au-delà de laquelle lesdites nano-structures commencent à se toucher. Ainsi, on peut contrôler la densité desdites nano-structures sur une large gamme entre 10⁹ et quelques 10¹²/cm².

Par ailleurs, du fait de la séparation des étapes de germination et de croissance, la distribution en taille des nano-structures obtenues par ce procédé est très fine.

Il est à noter que, dans le cas des nano-structures de germanium, la pureté des nano-structures obtenues est importante car la taille des germes formés durant la première étape de CVD est petite comparée à celle des nano-structures finales.

Grâce à ce procédé, la taille moyenne des nano-structures de silicium peut être contrôlée avec précision et peut être modifiée facilement sans avoir à changer les conditions de dépôt : il suffit de modifier le temps de dépôt de la deuxième étape pour avoir des nano-structures de la taille voulue. Au contraire, dans le cas d'un procédé en une seule étape, une modification du temps de dépôt engendrerait une modification de la taille moyenne des nano-structures, mais aussi de leur densité. Il faudrait donc aussi modifier les conditions de dépôt, pression et température pour retrouver la densité de nano-structures de silicium recherchée.

### BRÈVE DESCRIPTION DES DESSINS

L'invention sera mieux comprise et d'autres avantages et particularités apparaîtront à la lecture de la description qui va suivre, donnée à titre d'exemple non limitatif, et accompagnée des dessins annexés parmi lesquels :
- les figures 1A à 1C, déjà décrites précédemment, illustrent le processus de croissance des nano-structures de silicium par CVD en une seule étape, selon l'art antérieur,
- les figures 2A à 2C illustrent le processus de croissance des nano-structures de silicium, ou de germanium, par CVD en deux étapes, selon l'invention.

### EXPOSÉ DÉTAILLÉ DE MODES DE RÉALISATION PARTICULIERS

La figure 2A illustre ce qui se passe lors de la première étape de CVD : on envoie sur le substrat 13 recouvert d'une couche de diélectrique 12 un gaz 11, précurseur, qui va permettre la formation de germes 14 sur le diélectrique 12. C'est la phase de nucléation.

Puis dans la deuxième étape de CVD (figure 2B), on envoie un gaz précurseur 21 des nano-structures 16A que l'on veut obtenir, c'est-à-dire des nano-structures de germanium ou de silicium selon le cas, et celles ci vont croître sélectivement sur les germes 14 formés pendant la première étape, préférentiellement au substrat diélectrique 12. C'est la phase de croissance.

Après les deux étapes CVD, on obtient un dispositif présentant des nano-structures de taille homogène 16 B(figure 2C).

La partie qui suit va porter sur la description détaillée du procédé de réalisation de nano-structures de germanium sur un substrat diélectrique de silice selon l'invention. On a vu précédemment que ce procédé comprend deux étapes de CVD :
- la première étape où des germes stables de silicium sont déposés sur le substrat diélectrique (figure 2A),
- la deuxième étape où les nano-structures de germanium croissent sélectivement sur les germes formés pendant la première étape par rapport au substrat diélectrique (figure 2B).

Le but de la première étape est de fonctionnaliser de façon discrète la surface du substrat diélectrique de silice pour permettre la croissance des nano-structures de germanium.

Les germes de silicium, le terme de germe désignant un amas de quelques dizaines à quelques milliers d'atomes, sont toujours très petits par rapport à la taille des nano-structures finales de germanium.

On a vu dans l'introduction que pour utiliser les propriétés de rétention de charge/blocage de coulomb des nano-structures semi-conductrices, il fallait que la densité des germes soit comprise entre 10⁹ et quelques 10¹²/cm². Par ailleurs, la distance entre les germes doit être supérieure au diamètre voulu des nano-structures de germanium afin que ces dernières ne coalescent pas.

Pour résumer, les conditions expérimentales doivent être telles qu'il se forme une forte densité de germes stables répartis uniformément sur le substrat et de manière à ce que la formation des germes soit la plus instantanée possible, ceci afin que les germes aient tous la même taille.

Pour satisfaire à tous ces critères, les conditions opératoires doivent être parfaitement maîtrisées.

Tout d'abord, l'exposition de la surface doit être réalisée à une température suffisante pour que le précurseur du silicium puisse se dissocier et engendrer la formation d'un germe cristallin. Cependant, la température du dépôt doit également être choisie la plus basse possible afin, de limiter la vitesse de croissance des germes. Par exemple, dans le cas du silane comme précurseur du silicium, la formation des germes de silicium se fait avantageusement à une température comprise entre 550°C et 700°C.

La pression partielle du précurseur du silicium doit être faible pour que la vitesse de croissance des germes soit lente. Dans le cas du silane comme précurseur du silicium, la pression partielle de silane est préférentiellement inférieure à environ 133 Pa (1 Torr). Le précurseur pourra être dilué dans un gaz vecteur ou non.

Le temps de dépôt sera choisi en fonction de la densité de germes souhaitée. Dans le cas d'une exposition du substrat diélectrique à du silane à des pressions partielles inférieures à environ 1,33 Pa (10 mTorr), le temps d'exposition de la surface au gaz est inférieur à 15 minutes.
Dans le cas du silane utilisé à des pressions partielles inférieures à environ 133 Pa (1 Torr), le temps d'exposition de la surface au gaz est inférieur à 1 minute.

Pour obtenir de fortes densités de germes, le substrat diélectrique doit être le plus réactif possible avec le précurseur du silicium, ceci afin de favoriser la formation des germes plutôt que la diffusion du précurseur à sa surface. Dans le cas d'une exposition du substrat diélectrique à du silane, de fortes densités de germes sont formées sur Si₃N₄, Al₂O₃, HfO₂ ou SiO₂ ayant une forte densité de groupes Si-OH à sa surface.

La densité spatiale des germes formés pendant cette première étape détermine la densité finale de nano-structures de germanium. La densité des germes peut être contrôlée par les propriétés chimiques de surface du substrat et la disposition de ces germes peut être contrôlée suivant le procédé décrit dans le document **[4]** référencé à la fin de cette description.

Pendant la deuxième étape de CVD, les nano-structures de germanium vont croître sélectivement sur les germes formés pendant la première étape par rapport au substrat diélectrique. Le précurseur du germanium est préférentiellement le germane, mais pourra être aussi un autre précurseur dans la mesuré, où il engendre un dépôt sélectif sur le germe formé pendant la première étape de CVD par rapport au diélectrique.

La croissance des nano-structures de germanium se fait dans les conditions classiques du dépôt de germanium sur silicium par CVD : la température doit être comprise entre 300°C et 1000°C, la pression partielle du précurseur du germanium doit être inférieure à environ 133 Pa (1 Torr) et le temps de dépôt doit être calculé de manière à obtenir des nano-structures de la taille voulue.

La taille des nano-structures est contrôlée par les conditions de dépôt (la pression, la température et le temps) de cette deuxième étape de dépôt CVD. On se place préférentiellement dans des conditions de procédé telles que la vitesse de croissance des nano-structures soit faible, ceci afin de pouvoir contrôler avec précision la taille desdites nano-structures. On se placera donc à une faible pression partielle du précurseur du germanium et à une température de dépôt basse mais permettant sa dissociation à la surface du substrat.

Le procédé selon l'invention permet également d'élaborer des nano-structures de silicium dont la dispersion en taille est beaucoup plus faible par rapport à la méthode décrite dans la littérature par dépôt de silane en une seule étape **[1]**. Pour cela, le germe de silicium est formé au cours de la première étape de CVD comme décrit ci-dessus (figure 2A) et on utilise, pour la deuxième étape CVD, un précurseur du silicium permettant d'engendrer un dépôt sélectif sur le germe de silicium créé par rapport au substrat diélectrique (figure 2B). On peut, par exemple, utiliser du dichlorosilane comme précurseur du silicium. Dans ce cas, le dépôt de silicium à partir de dichlorosilane peut être réalisé à des températures variant entre 300°C et 1000°C, et pour des pressions partielles du précurseur inférieures à environ 133 Pa (1 Torr).

Dans ces conditions, l'invention permet d'éliminer une des principales causes de la dispersion en taille des nano-structures de silicium obtenues par CVD en une seule étape. Cette cause, qui est intrinsèque à cette méthode d'élaboration en une étape de dépôt, est que les phases de nucléation et de croissance sont simultanées. En effet, dans le cas du dépôt de nano-cristaux de silicium sur diélectrique, il a été mesuré que la taille moyenne et la densité de ces nano-cristaux augmentent continuellement et simultanément jusqu'à la coalescence (voir le document **[5]** à la fin de cette description). L'invention permet de dissocier ces étapes de nucléation et de croissance conduisant à la formation des nano-structures de silicium par CVD. Il en résulte une dispersion en taille nettement plus petite des nano-structures obtenues par rapport au procédé en une seule étape de CVD décrit dans la littérature. Par exemple, alors que les nano-structures de silicium élaborées par CVD à partir de silane en une seule étape ont une dispersion en taille de 50% **[1]**, les nano-cristaux de silicium élaborés suivant le procédé en deux étapes de dépôt décrit ci-dessus, en utilisant le silane dans la première étape et le dichlorosilane dans la deuxième étape de CVD, ont une dispersion en taille inférieure à 20%.

Ces nano-structures de silicium ou de germanium peuvent être dopées par co-déposition ou par implantation avec des éléments tels que le bore, le phosphore, l'arsenic, l'erbium pour, par exemple, améliorer leurs propriétés de luminescence ou de rétention.

Ces nano-structures peuvent également être encapsulées par dépôt d'un diélectrique. Par exemple, ces nano-structures ainsi encapsulées pourront être utilisées pour une application mémoire, où la charge sous forme d'électrons accède aux nano-structures, qui sont ici des points de stockage, au travers d'un film mince de diélectrique. De même, ces nano-structures encapsulées pourront être utilisées pour une application de lecture.

On va maintenant décrire plus précisément deux exemples de réalisation d'un dispositif selon l'invention.

Le premier exemple illustre la réalisation de nano-structures de germanium sur un substrat de silicium présentant une fine couche de diélectrique sous forme de silice. Le substrat de base est du silicium <100> de résistivité comprise entre 7 et 10 Ω.m et dopé p. On procède à une oxydation de ce substrat à 800°C dans un four : une couche d'oxyde de 7 nm d'épaisseur est ainsi formée.

Pendant la première étape de CVD, des germes de silicium sont déposés à partir du précurseur SiH₄ à 600°C, sous une pression partielle d'environ 8 Pa (60 mTorr) et pendant une durée de 15 s. Les germes de silicium obtenus sont de taille inférieure à 1 nm et sont non détectables en microscopie à balayage haute résolution.

Au cours de la deuxième étape, des nano-structures de germanium vont être déposées par CVD à partir du précurseur GeH₄ à 600°C, sous une pression partielle d'environ 1,20 Pa (9 mTorr) et pendant une durée de 15 s. On obtient des nano-cristaux de germanium de 15 nm de diamètre en moyenne, avec une dispersion en taille inférieure à 20%. Leur densité est de 5.10⁹ nano-cristaux/cm² et la quantité de silicium dans la nano-structure de germanium est si faible qu'elle est indétectable par des techniques telles que l'XPS.

Le deuxième exemple illustre quant à lui la réalisation de nano-structures de silicium sur un substrat de silicium présentant une fine couche de diélectrique sous forme de silice. Le substrat de base est du silicium <100> de résistivité comprise entre 7 et 10 Ω.m et dopé p. On procède à une oxydation de ce substrat à 800°C dans un four : une couche d'oxyde de 7 nm d'épaisseur est ainsi formée.

Pendant la première étape, des nano-structures de silicium sont déposées par CVD à partir du précurseur SiH₄ à 600°C, sous une pression partielle d'environ 8 Pa (60 mTorr) et pendant une durée de 15 s. Les germes de silicium obtenus sont de taille inférieure à 1nm et sont non détectables en microscopie à balayage haute résolution.

Pendant la deuxième étape, des nano-structures de germanium vont être déposées par CVD à partir de SiH₂Cl₂ à 650°C, sous une pression partielle d'environ 8 Pa (60 mTorr) et pendant une durée de 300 s. On obtient des nano-cristaux de silicium de 5 nm de diamètre moyen avec une dispersion en taille inférieure à 20%. La densité est de 5.10⁹ nano-cristaux/cm².

### BIBLIOGRAPHIE

[1] T. BARON, F. MARTIN, P. MUR, C. WYON, Journal of Crystal Growth 209, 1004-1008 (2000).
[2] H. ISHII, Y. TAKAHASHI, J MUROTA, Applied Physics Letter 47, 863-865 (1985).
[3] OZTURK, MEHMET, WORTMAN, JIMMIE, US Patent n°5,250,452.
**[4]** M.N. SEMERIA, P. MUR, F. MARTIN, F. FOURNEL, H. MORICEAU, J. EYMERY, N. MAGNEA, T. BARON, demande de brevet FR-A-2 815 026.
[5] S. MADHUKAR, K. SMITH, R. MURALIDHAR, D. O'MERAR, M. SADD, B-Y NGUYEN, B. WHITE, B. JONES, Material Research Society Symposium Proceedings 638, F 5.2.1 (2001).
**[6]** A. FERNANDES et al., Memory characteristics of Si quantum dot devices with SiO2/ALD Al2O3 tunneling dielectrics.

## Revendications (Revendications pour l'(les) Etat(s) contractant(s) suivant(s): AT, BE, CH, DK, ES, GR, LI, LU, MC, NL, SE)

1. Procédé de réalisation de nano-structures de matériau semi-conducteur sur un substrat de matériau diélectrique par dépôt chimique en phase vapeur (CVD), comprenant la formation, sur le substrat (12), de germes stables (14) d'un premier matériau semi-conducteur sous forme d'îlots et la formation de nano-structures (16A, 16B) d'un deuxième matériau semi-conducteur à partir des germes stables (14) du premier matériau semi-conducteur,
dans lequel la formation des germes stables est obtenue par une première étape de dépôt CVD réalisé à partir d'un précurseur (11) du premier matériau semi-conducteur choisi pour que le matériau diélectrique (12) accepte la formation desdits germes (14)
et dans lequel la formation des nano-structures (16A, 16B) d'un deuxième matériau sémi-conducteur à partir des germes stables (14) du premier matériau semi-conducteur est obtenue par une deuxième étape de dépôt CVD, le procédé étant **caractérisé en ce que** ladite deuxième étape de dépôt CVD est réalisée à partir d'un précurseur (21) différent du précurseur (11) du premier matériau semi-conducteur et choisi pour engendrer un dépôt sélectif du deuxième matériau semi-conducteur sur lesdits germes (14), plutôt que sur le substrat de matériau diélectrique.

2. Procédé selon la revendication 1 dans lequel le premier et le deuxième matériau semi-conducteur sont du silicium.

3. Procédé selon la revendication 1 dans lequel le premier matériau semi-conducteur est du silicium et le deuxième matériau semi-conducteur est du germanium.

4. Procédé selon l'une des revendications précédentes dans lequel le substrat de matériau diélectrique (12) est choisi de manière à ce qu'il soit le plus réactif possible avec le précurseur (11) du premier matériau semi-conducteur.

5. Procédé selon la revendication 1 dans lequel le substrat de matériau diélectrique (12) est choisi parmi le groupe composé de SiO₂, SiO₂ avec une forte densité de groupes Si-OH à sa surface, Si₃N₄, Al₂O₃ et HfO₂.

6. Procédé selon la revendication 1 dans lequel la première étape de CVD pour la formation de germes stables (14) d'un premier matériau semi-conducteur est réalisée pendant un temps d'exposition choisi en fonction de la densité de germes souhaitée.

7. Procédé selon la revendication 1 dans lequel la deuxième étape de CVD pour la formation de nano-structures (16A) d'un deuxième matériau semi-conducteur est réalisée pendant un temps d'exposition choisi en fonction de la taille des nano-structures (16B) voulue.

8. Procédé selon la revendication 1 dans lequel la première et la deuxième étape de CVD sont réalisées pour une pression partielle de précurseur (11, 21) faible.

9. Procédé selon la revendication 2 ou 3 dans lequel le précurseur (11) du premier matériau semi-conducteur est le silane.

10. Procédé selon la revendication 9 dans lequel la première étape de CVD pour la formation des germes (14) du premier matériau semi-conducteur se fait à une température comprise entre 550°C et 700°C et pour une pression partielle du silane inférieure à environ 133 Pa (1 Torr).

11. Procédé selon la revendication 9 dans lequel, la première étape de CVD pour la formation de germes stables (14) d'un premier matériau semi-conducteur se faisant à des pressions partielles inférieures à environ 1,33 Pa (10 mTorr), le temps d'exposition du substrat au précurseur (11) du premier matériau semi-conducteur est inférieur à 15 minutes.

12. Procédé selon la revendication 9 dans lequel, la première étape de CVD pour la formation de germes stables (14) du premier matériau semi-conducteur se faisant à des pressions partielles inférieures à environ 133 Pa (1 Torr), le temps d'exposition du substrat au précurseur (11) du premier matériau semi-conducteur est inférieur à 1 minute.

13. Procédé selon la revendication 2 dans lequel le précurseur (21) du deuxième matériau semi-conducteur est le dichlorosilane.

14. Procédé selon la revendication 3 dans lequel le précurseur (21) du deuxième matériau semi-conducteur est le germane.

15. Procédé selon la revendication 13 ou 14 dans lequel la deuxième étape de CVD pour la formation de nano-structures (16A) est réalisée à une température comprise entre 300°C et 1000°C et pour une pression partielle du précurseur (21) inférieure à environ 133 Pa (1 Torr).

16. Procédé selon l'une quelconque des revendications 1 à 15, comprenant en outre une étape de dopage des nano-structures par co-déposition ou par implantation avec des éléments tels que le bore, le phosphore, l'arsenic ou l'erbium.

17. Procédé selon l'une quelconque des revendications 1 à 16, comprenant en outre une étape d'encapsulation des nano-structures par dépôt d'un diélectrique.

## Revendications (Revendications pour l'(les) Etat(s) contractant(s) suivant(s): DE, FR, GB, IT)

1. Procédé de réalisation de nano-structures de matériau semi-conducteur sur un substrat de matériau diélectrique par dépôt chimique en phase vapeur (CVD), comprenant la formation, sur le substrat (12), de germes stables (14) d'un premier matériau semi-conducteur sous forme d'îlots et la formation de nano-structures (16A, 16B) d'un deuxième matériau semi-conducteur à partir des germes stables (14) du premier matériau semi-conducteur,
dans lequel la formation des germes stables est obtenue par une première étape de dépôt CVD réalisé à partir d'un précurseur (11) du premier matériau semi-conducteur choisi pour que le matériau diélectrique (12) accepte la formation desdits germes (14)
et dans lequel la formation des nano-structures (16A, 16B) d'un deuxième matériau semi-conducteur à partir des germes stables (14) du premier matériau semi-conducteur est obtenue par une deuxième étape de dépôt CVD réalisé à partir d'un précurseur (21) différent du précurseur (11) du premier matériau semi-conducteur et choisi pour engendrer un dépôt sélectif du deuxième matériau semi-conducteur sur lesdits germes (14), plutôt que sur le substrat de matériau diélectrique,
le premier et le deuxième matériau semi-conducteur étant du silicium,
et le précurseur (21) du deuxième matériau semi-conducteur étant le dichlorosilane.

2. Procédé de réalisation de nano-structures de matériau semi-conducteur sur un substrat de matériau diélectrique par dépôt chimique en phase vapeur (CVD), comprenant la formation, sur le substrat (12), de germes stables (14) d'un premier matériau semi-conducteur sous forme d'îlots et la formation de nano-structures (16A, 16B) d'un deuxième matériau semi-conducteur à partir des germes stables (14) du premier matériau semi-conducteur,
dans lequel la formation des germes stables est obtenue par une première étape de dépôt CVD réalisé à partir d'un précurseur (11) du premier matériau semi-conducteur choisi pour que le matériau diélectrique (12) accepte la formation desdits germes (14)
et dans lequel la formation des nano-structures (16A, 16B) d'un deuxième matériau semi-conducteur à partir des germes stables (14) du premier matériau semi-conducteur est obtenue par une deuxième étape de dépôt CVD, le procédé étant **caractérisé en ce que** ladite deuxième étape de dépot CVD est réalisée à partir d'un précurseur (21) différent du précurseur (11) du premier matériau semi-conducteur et choisi pour engendrer un dépôt sélectif du deuxième matériau semi-conducteur sur lesdits germes (14),
le premier matériau semi-conducteur étant du silicium et le deuxième matériau semi-conducteur étant du germanium,
et le précurseur (21) du deuxième matériau semi-conducteur étant le germane.

3. Procédé selon la revendication 1 ou 2, dans lequel la première étape de CVD pour la formation de nano-structures (16A) est réalisée à une température comprise entre 300°C et 1000°C et pour une pression partielle du précurseur (21) inférieure à environ 133 Pa (1 Torr).

4. Procédé selon l'une quelconque des revendications 1 à 3, comprenant en outre une étape de dopage des nano-structures par co-dépositionou par implantation avec des éléments choisis parmi le bore, le phosphore, l'arsenic ou l'erbium.

5. Procédé selon l'une quelconque des revendications 1 à 4, comprenant en outre une étape d'encapsulation des nano-structures par dépôt d'un diélectrique.

6. Procédé selon l'une quelconque des revendications 1 à 5, dans lequel le précurseur (11) du premier matériau semi-conducteur est le silane.

## Patentansprüche (Patentansprüche für folgende(n) Vertragsstaat(en): AT, BE, CH, DK, ES, GR, LI, LU, MC, NL, SE)

1. Verfahren zum Herstellen von Nanostrukturen aus Halbleitermaterial auf einem Substrat aus dielektrischem Material durch chemische Gasphasenabscheidung (CVD), umfassend das Bilden stabiler Keime (14) aus einem ersten Halbleitermaterial in Form von Inseln auf dem Substrat (12) und das Bilden von Nanostrukturen (16A, 16B) aus einem zweiten Halbleitermaterial ausgehend von den stabilen Keimen (14) aus dem ersten Halbleitermaterial,
wobei das Bilden der stabilen Keime durch einen ersten CVD-Abscheidungsschritt erhalten wird, der ausgehend von einem Vorläufer (11) des ersten Halbleitermaterials erfolgt, der so gewählt ist, dass das dielektrische Material (12) das Bilden der Keime (14) zulässt,
und wobei das Bilden der Nanostrukturen (16A, 16B) aus einem zweiten Halbleitermaterial ausgehend von den stabilen Keimen (14) aus dem ersten Halbleitermaterial durch einen zweiten CVD-Abscheidungsschritt erhalten wird,
wobei das Verfahren **dadurch gekennzeichnet ist, dass**
der zweite CVD-Abscheidungsschritt ausgehend von einem Vorläufer (21) erfolgt, der sich von dem Vorläufer (11) des ersten Halbleitermaterials unterscheidet und so gewählt ist, dass eine selektive Abscheidung des zweiten Halbleitermaterials vielmehr auf den Keimen (14) als auf dem Substrat aus dielektrischem Material hervorgerufen wird.

2. Verfahren nach Anspruch 1, wobei das erste und das zweite Halbleitermaterial Silicium sind.

3. Verfahren nach Anspruch 1, wobei das erste Halbleitermaterial Silicium ist und das zweite Halbleitermaterial Germanium ist.

4. Verfahren nach einem der vorangehenden Ansprüche, wobei das Substrat aus dielektrischem Material (12) so gewählt ist, dass es möglichst reaktiv mit dem Vorläufer (11) des ersten Halbleitermaterials ist.

5. Verfahren nach Anspruch 1, wobei das Substrat aus dielektrischem Material (12) ausgewählt ist aus der Gruppe umfassend SiO₂, SiO₂ mit einer hohen Dichte an Si-OH-Gruppen an seiner Oberfläche, Si₃N₄, Al₂O₃ und HfO₂.

6. Verfahren nach Anspruch 1, wobei der erste CVD-Schritt zum Bilden von stabilen Keimen (14) aus einem ersten Halbleitermaterial während einer Expositionszeit erfolgt, die in Abhängigkeit von der gewünschten Keimdichte gewählt ist.

7. Verfahren nach Anspruch 1, wobei der zweite CVD-Schritt zum Bilden von Nanostrukturen (16A) aus einem zweiten Halbleitermaterial während einer Expositionszeit erfolgt, die in Abhängigkeit von der gewünschten Größe der Nanostrukturen (16B) gewählt ist.

8. Verfahren nach Anspruch 1, wobei der erste und der zweite CVD-Schritt bei einem geringen Partialdruck des Vorläufers (11, 21) erfolgen.

9. Verfahren nach Anspruch 2 oder 3, wobei der Vorläufer (11) des ersten Halbleitermaterials Silan ist.

10. Verfahren nach Anspruch 9, wobei der erste CVD-Schritt zum Bilden der Keime (14) aus dem ersten Halbleitermaterial bei einer Temperatur zwischen 550 °C und 700 °C und bei einem Partialdruck von Silan unter etwa 133 Pa (1 Torr) erfolgt.

11. Verfahren nach Anspruch 9, wobei bei dem ersten CVD-Schritt zum Bilden von stabilen Keimen (14) aus einem ersten Halbleitermaterial, der bei Partialdruckwerten unter etwa 1,33 Pa (10 mTorr) erfolgt, die Expositionszeit des Substrats gegenüber dem Vorläufer (11) des ersten Halbleitermaterials unter 15 Minuten beträgt.

12. Verfahren nach Anspruch 9, wobei bei dem ersten CVD-Schritt zum Bilden von stabilen Keimen (14) aus dem ersten Halbleitermaterial, der bei Partialdruckwerten unter etwa 133 Pa (1 Torr) erfolgt, die Expositionszeit des Substrats gegenüber dem Vorläufer (11) des ersten Halbleitermaterials unter 1 Minute beträgt.

13. Verfahren nach Anspruch 2, wobei der Vorläufer (21) des zweiten Halbleitermaterials Dichlorsilan ist.

14. Verfahren nach Anspruch 3, wobei der Vorläufer (21) des zweiten Halbleitermaterials German ist.

15. Verfahren nach Anspruch 13 oder 14, wobei der zweite CVD-Schritt zum Bilden von Nanostrukturen (16A) bei einer Temperatur zwischen 300 °C und 1000 °C und bei einem Partialdruck des Vorläufers (21) unter etwa 133 Pa (1 Torr) erfolgt.

16. Verfahren nach einem der Ansprüche 1 bis 15, ferner umfassend einen Schritt des Dotierens der Nanostrukturen durch Co-Abscheidung oder durch Implantieren mit Elementen wie Bor, Phosphor, Arsen oder Erbium.

17. Verfahren nach einem der Ansprüche 1 bis 16, ferner umfassend einen Schritt des Einkapselns der Nanostrukturen durch Abscheidung eines Dielektrikums.

## Patentansprüche (Patentansprüche für folgende(n) Vertragsstaat(en): DE, FR, GB, IT)

1. Verfahren zum Herstellen von Nanostrukturen aus Halbleitermaterial auf einem Substrat aus dielektrischem Material durch chemische Gasphasenabscheidung (CVD), umfassend das Bilden stabiler Keime (14) aus einem ersten Halbleitermaterial in Form von Inseln auf dem Substrat (12) und das Bilden von Nanostrukturen (16A, 16B) aus einem zweiten Halbleitermaterial ausgehend von den stabilen Keimen (14) aus dem ersten Halbleitermaterial,
wobei das Bilden der stabilen Keime durch einen ersten CVD-Abscheidungsschritt erhalten wird, der ausgehend von einem Vorläufer (11) des ersten Halbleitermaterials erfolgt, der so gewählt ist, dass das dielektrische Material (12) das Bilden der Keime (14) zulässt,
und wobei das Bilden der Nanostrukturen (16A, 16B) aus einem zweiten Halbleitermaterial ausgehend von den stabilen Keimen (14) aus dem ersten Halbleitermaterial durch einen zweiten CVD-Abscheidungsschritt erhalten wird, der ausgehend von einem Vorläufer (21) erfolgt, der sich von dem Vorläufer (11) des ersten Halbleitermaterials unterscheidet und so gewählt ist, dass eine selektive Abscheidung des zweiten Halbleitermaterials vielmehr auf den Keimen (14) als auf dem Substrat aus dielektrischem Material hervorgerufen wird,
wobei das erste und das zweite Halbleitermaterial Silicium sind, und wobei der Vorläufer (21) des zweiten Halbleitermaterials Dichlorsilan ist.

2. Verfahren zum Herstellen von Nanostrukturen aus Halbleitermaterial auf einem Substrat aus dielektrischem Material durch chemische Gasphasenabscheidung (CVD), umfassend das Bilden stabiler Keime (14) aus einem ersten Halbleitermaterial in Form von Inseln auf dem Substrat (12) und das Bilden von Nanostrukturen (16A, 16B) aus einem zweiten Halbleitermaterial ausgehend von den stabilen Keimen (14) aus dem ersten Halbleitermaterial,
wobei das Bilden der stabilen Keime durch einen ersten CVD-Abscheidungsschritt erhalten wird, der ausgehend von einem Vorläufer (11) des ersten Halbleitermaterials erfolgt, der so gewählt ist, dass das dielektrische Material (12) das Bilden der Keime (14) zulässt,
und wobei das Bilden der Nanostrukturen (16A, 16B) aus einem zweiten Halbleitermaterial ausgehend von den stabilen Keimen (14) aus dem ersten Halbleitermaterial durch einen zweiten CVD-Abscheidungsschritt erhalten wird,
wobei das Verfahren **dadurch gekennzeichnet ist, dass**
der zweite CVD-Abscheidungsschritt ausgehend von einem Vorläufer (21) erfolgt, der sich von dem Vorläufer (11) des ersten Halbleitermaterials unterscheidet und so gewählt ist, dass eine selektive Abscheidung des zweiten Halbleitermaterials auf den Keimen (14) hervorgerufen wird,
wobei das erste als Halbleitermaterial Silicium ist und das zweite Halbleitermaterial Germanium ist,
und wobei der Vorläufer (21) des zweiten Halbleitermaterials German ist.

3. Verfahren nach Anspruch 1 oder 2, wobei der erste CVD-Schritt zum Bilden von Nanostrukturen (16A) bei einer Temperatur zwischen 300 °C und 1000 °C und bei einem Partialdruck des Vorläufers (21) unter etwa 133 Pa (1 Torr) erfolgt.

4. Verfahren nach einem der Ansprüche 1 bis 3, ferner umfassend einen Schritt des Dotierens der Nanostrukturen durch Co-Abscheidung oder durch Implantieren mit Elementen ausgewählt aus Bor, Phosphor, Arsen oder Erbium.

5. Verfahren nach einem der Ansprüche 1 bis 4, ferner umfassend einen Schritt des Einkapselns der Nanostrukturen durch Abscheidung eines Dielektrikums.

6. Verfahren nach einem der Ansprüche 1 bis 5, wobei Vorläufer (11) des ersten Halbleitermaterials Silan ist.

## Claims (Claims for the following Contracting State(s): AT, BE, CH, DK, ES, GR, LI, LU, MC, NL, SE)

1. A method for forming nanostructures of semi-conductor material on a substrate of dielectric material by chemical vapour deposition (CVD), comprising the formation, on the substrate (12), of stable nuclei (14) of a first semi-conductor material in the form of islands and the formation of nanostructures (16A, 16B) of a second semi-conductor material from the stable nuclei (14) of the first semi-conductor material,
wherein the formation of the stable nuclei is obtained by a first CVD step carried out with a precursor (11) of the first semi-conductor material chosen so that the dielectric material (12) accepts the formation of said nuclei (14)
and wherein the formation of the nanostructures (16A, 16B) of a second semi-conductor material from the stable nuclei (14) of the first semiconductor material is obtained by a second CVD step,
the method being **characterised in that** the second CVD step is carried out with a precursor (21) different from the precursor (11) of the first semi-conductor material and chosen to generate a selective deposition of the second semi-conductor material on said nuclei (14), instead of on the substrate of dielectrical material.

2. A method according to claim 1, wherein the first and second semi-conductor materials are silicon.

3. A method according to claim 1, wherein the first semi-conductor material is silicon and the second semi-conductor material is germanium.

4. A method according to one of the previous claims, wherein the substrate of dielectric material (12) is chosen in such a way that it is as reactive as possible with the precursor (11) of the first semi-conductor material.

5. A method according to claim 1, wherein the substrate of dielectric material (12) is chosen from among the group comprising SiO₂, SiO₂ with a high density of Si-OH groups on its surface, Si₃N₄, Al₂O₃ and HfO₂.

6. A method according to claim 1, wherein the first CVD step of forming stable nuclei (14) of a first semi-conductor material is carried out for an exposure time chosen as a function of the desired density of nuclei.

7. A method according to claim 1, wherein the second CVD step of forming nanostructures (16A) of a second semi-conductor material is carried out for an exposure time chosen as a function of the desired size of nanostructures (16B).

8. A method according to claim 1, wherein the first and second CVD steps are carried out with a low partial pressure of precursor (11, 21).

9. A method according to claim 2 or 3, wherein the precursor (11) of the first semi-conductor material is silane.

10. A method according to claim 9, wherein the first CVD step of forming nuclei (14) of the first semi-conductor material is carried out at a temperature between 550 °C and 700 °C and with a low partial pressure of silane, less than around 133 Pa (1 Torr).

11. A method according to claim 9, wherein the first CVD step of forming stable nuclei (14) of a first semi-conductor material being carried out at partial pressures less than around 1.33 Pa (10 mTorr), the exposure time of the substrate to the precursor (11) of the first semi-conductor material is less than 15 minutes.

12. A method according to claim 9, wherein the first CVD step of forming stable nuclei (14) of the first semi-conductor material being carried out at partial pressures less than around 133 Pa (1 Torr), the exposure time of the substrate to the precursor (11) of the first semi-conductor material is less than 1 minute.

13. A method according to claim 2, wherein the precursor (21) of the second semi-conductor material is dichlorosilane.

14. A method according to claim 3, wherein the precursor (21) of the second semi-conductor material is germane.

15. A method according to claim 13 or 14, wherein the second CVD step of forming nanostructures (16A) is carried out at a temperature between 300 °C and 1000 °C and with a partial pressure of the precursor (21) less than around 133 Pa (1 Torr).

16. A method according to any one of the claims 1 to 15, further comprising a step of doping the nanostructures by co-deposition or by implantation with elements such as boron, phosphorous, arsenic or erbium.

17. A method according to any one of claims 1 to 16, further comprising a step of encapsulating the nanostructures by deposition of a dielectric.

## Claims (Claims for the following Contracting State(s): DE, FR, GB, IT)

1. A method for forming nanostructures of semi-conductor material on a substrate of dielectric material by chemical vapour deposition (CVD), comprising the formation, on the substrate (12), of stable nuclei (14) of a first semi-conductor material in the form of islands and the formation of nanostructures (16A, 16B) of a second semi-conductor material from the stable nuclei (14) of the first semi-conductor material,
wherein the formation of the stable nuclei is obtained by a first CVD step carried out with a precursor (11) of the first semi-conductor material chosen so that the dielectric material (12) accepts the formation of said nuclei (14)
and wherein the formation of the nanostructures (16A, 16B) of a second semi-conductor material from the stable nuclei (14) of the first semiconductor material is obtained by a second CVD step carried out with a precursor (21) different from the precursor (11) of the first semi-conductor material and chosen to generate a selective deposition of the second semi-conductor material on said nuclei (14), instead of on the substrate of dielectrical material,
the first and second semi-conductor materials being silicon,
and the precursor (21) of the second semi-conductor being dichlorosilane.

2. A method for forming nanostructures of semi-conductor material on a substrate of dielectric material by chemical vapour deposition (CVD), comprising the formation, on the substrate (12), of stable nuclei (14) of a first semi-conductor material in the form of islands and the formation of nanostructures (16A, 16B) of a second semi-conductor material from the stable nuclei (14) of the first semi-conductor material,
wherein the formation of the stable nuclei is obtained by a first CVD step carried out with a precursor (11) of the first semi-conductor material chosen so that the dielectric material (12) accepts the formation of said nuclei (14)
and wherein the formation of the nanostructures (16A, 16B) of a second semi-conductor material from the stable nuclei (14) of the first semiconductor material is obtained by a second CVD step,
the method being **characterised in that** the second CVD step is carried out with a cprecursor (21) different from the precursor (11) of the first semi-conductor material and chosen to generate a selective deposition of the second semi-conductor material on said nuclei (14),
the first semi-conductor materials being silicon et the second semi-conductor material being germanium,
and the precursor (21) of the second semi-conductor material being germane.

3. A method according to claim 1 or 2, wherein the first CVD step of forming nanostructures (16A) is carried out at a temperature between 300 °C and 1000 °C and with a partial pressure of the precursor (21) less than around 133 Pa (1 Torr).

4. A method according to any one of the claims 1 to 3, further comprising a step of doping the nanostructures by co-deposition or by implantation with elements such as boron, phosphorousn, arsenic or erbium.

5. A method according to any one of the claims 1 to 4, further comprising a step of encapsulating the nanostructures by deposition of a dielectric.

6. A method according to any one of the claims 1 to 5, wherein the precursor (11) of the first semi-conductor material is silane.
